# EUROPEAN PATENT APPLICATION

(11) **EP 4 745 945 A1**
(43) Date of publication of application: **20.05.2026**
(21) Application number: 24896068.4
(22) Date of filing: 21.10.2024
(51) Int. Cl.: G09F 9/33, H01L 25/16

(54) **DISPLAY MODULE AND PREPARATION METHOD THEREFOR, AND ELECTRONIC DEVICE**

(30) Priority: 27.11.2023 CN 202311604262
(71) Applicant: Huawei Technologies Co., Ltd., Shenzhen, Guangdong 518129 (CN)
(72) Inventor: JIANG, Fulong, Shenzhen, Guangdong 518129 (CN); LIU, Jinqiang, Shenzhen, Guangdong 518129 (CN); WANG, Lei, Shenzhen, Guangdong 518129 (CN); YANG, Liuqing, Shenzhen, Guangdong 518129 (CN); YANG, Yina, Shenzhen, Guangdong 518129 (CN); ZHANG, Li, Shenzhen, Guangdong 518129 (CN)
(74) Representative: Goddar, Heinz J.
(86) International application number: PCT/CN2024/126133
(87) International publication number: WO 2025/112975

(57) **Abstract**

This application provides a display module and a preparation method thereof, and an electronic device, and relates to the field of display technologies, to resolve problems of low image quality of a display module and the like. The display module includes a drive backplane, a conductive grid, a transparent conductive layer, and a plurality of micro light-emitting diodes. The drive backplane includes a plurality of first electrode contacts and a second electrode contact. The micro light-emitting diode includes a first electrode and a second electrode. The plurality of micro light-emitting diodes are in a one-to-one correspondence with the plurality of first electrode contacts. The first electrode of the micro light-emitting diode is electrically connected to the corresponding first electrode contact. The conductive grid is electrically connected to the second electrode contact. The transparent conductive layer covers the plurality of micro light-emitting diodes and the conductive grid. The second electrode of the micro light-emitting diode is electrically connected to the conductive grid through the transparent conductive layer. Resistivity of a material of the conductive grid is lower than resistivity of a material of the transparent conductive layer.

## Description

This application claims priority to Chinese Patent Application No. 202311604262.4, filed with the China National Intellectual Property Administration on November 27, 2023 and entitled "DISPLAY MODULE AND PREPARATION METHOD THEREOF, AND ELECTRONIC DEVICE", which is incorporated herein by reference in its entirety.

### TECHNICAL FIELD

This application relates to the field of display technologies, and in particular, to a display module and a preparation method thereof, and an electronic device.

### BACKGROUND

With development of a micro-machining process, light-emitting diode (Light-emitting diode, LED) optical chips have gradually expanded from the lighting field to the display field. A micro (micro) LED display technology is a self-luminous display technology. A micro light-emitting diode is also referred to as a micron-level light-emitting diode, and is formed by integrating arrayed micron-level LED units (also referred to as LED units) onto a drive backplane with active driving functionality. A lower electrode of the micro LED is electrically connected to the drive backplane, and an upper electrode is electrically connected to a drive backplane through a transparent conductive material and a common electrode. The transparent conductive material used by the upper electrode has low electrical conductivity. This results in a great voltage drop (IR droop) in a high-resolution display screen, affecting display quality.

### SUMMARY

This application provides a display module and a preparation method thereof, and an electronic device, to resolve problems of low image quality of a display module and the like.

According to a first aspect, an embodiment of this application provides a display module. The display module includes a drive backplane, a plurality of micro light-emitting diodes, a conductive grid, and a transparent conductive layer. The drive backplane includes a plurality of first electrode contacts and a second electrode contact, and the first electrode contact and the second electrode contact are configured to form a drive loop with the micro light-emitting diode. The micro light-emitting diode includes a first electrode and a second electrode, the plurality of micro light-emitting diodes are in a one-to-one correspondence with a plurality of electrode contacts, and the first electrode of the micro light-emitting diode is electrically connected to the electrode contact. The conductive grid includes a plurality of grids, the micro light-emitting diode corresponds to the grid, and the conductive grid is electrically connected to the second electrode contact. The transparent conductive layer covers the plurality of micro light-emitting diodes and the conductive grid, the second electrode of the micro light-emitting diode is electrically connected to the conductive grid through the transparent conductive layer, and resistivity of a material of the conductive grid is lower than resistivity of a material of the transparent conductive layer.

The display module provided in this embodiment of this application is provided with the conductive grid. The conductive grid is electrically connected to the transparent conductive layer and a common electrode. The conductive grid is made of a material with good electrical conductivity, and a resistance of the conductive grid is lower than that of the transparent conductive layer. A current from the micro light-emitting diode may flow through the transparent conductive layer to a nearest conductive grid, and then flow through the conductive grid to the common electrode, forming a loop. Not all of the current need to flow through the transparent conductive layer to the common electrode. This can avoid a problem of a voltage drop caused by a high resistance of the transparent conductive layer, and improve image quality.

In a possible implementation, the common electrode is further disposed on the drive backplane. The common electrode is in contact with the second electrode contact and the conductive grid. The conductive grid is electrically connected to the second electrode contact through the common electrode. In this way, the first electrode of the micro light-emitting diode is electrically connected to the first electrode contact on the drive backplane, and the second electrode of the micro light-emitting diode can be connected to the second electrode contact sequentially through the transparent conductive layer, the conductive grid, and the common electrode.

In a possible implementation, the conductive grid is electrically connected to the second electrode contact through an internal line of the drive backplane. In this way, the first electrode of the micro light-emitting diode is electrically connected to the first electrode contact on the drive backplane, and the second electrode of the micro light-emitting diode can be connected to the second electrode contact sequentially through the transparent conductive layer, the conductive grid, and the internal line of the drive backplane.

In a possible implementation, a height control layer is further disposed on the drive backplane, and an upper surface of the micro light-emitting diode is flush with an upper surface of the height control layer. In this embodiment of this application, the height control layer is disposed, so that the upper surface of the micro light-emitting diode is flush with the upper surface of the height control layer, and a height of the micro light-emitting diode is precisely controlled by using the height control layer, to improve display effect.

In a possible implementation, the display module further includes a dielectric filling layer. The dielectric filling layer is disposed between adjacent micro light-emitting diodes and between the height control layer and the drive backplane. A material of the height control layer has a different removal rate from a material of the dielectric filling layer and a material of the micro light-emitting diode. During flattening of a wafer, a height of the wafer may stop at the upper surface of the height control layer by using different removal rates between the material of the height control layer, and the material of the dielectric filling layer and the material of the micro light-emitting diode, so that the upper surface of the micro light-emitting diode is flush with the upper surface of the height control layer, and the height of the micro light-emitting diode can be defined by the upper surface of the height control layer and a surface of the drive backplane.

In a possible implementation, a plurality of micro light-emitting diodes are disposed in a region defined by each grid. For example, the display module may be a color display module, each pixel includes a plurality of micro light-emitting diodes of different colors, the plurality of micro light-emitting diodes included in the pixel may be disposed in a region defined by a same grid, and the conductive grid may block light of the micro light-emitting diode, to avoid crosstalk of the light of the micro light-emitting diode of different pixels.

In a possible implementation, one micro light-emitting diode is disposed in a region defined by each grid. For example, the display module may be a monochrome display module, each pixel includes one monochrome micro light-emitting diode, the micro light-emitting diode is disposed in the grid, and the conductive grid may block light of the micro light-emitting diode, to avoid crosstalk of the light of different micro light-emitting diodes.

In a possible implementation, a width of a grid line of the conductive grid ranges from 10 nm to 1000 nm.

In a possible implementation, the conductive grid includes a lower surface facing the drive backplane and an upper surface facing away from the drive backplane in a direction perpendicular to the drive backplane. The micro light-emitting diode includes a lower surface facing the drive backplane and the upper surface facing away from the drive backplane in the direction perpendicular to the drive backplane. A distance from the lower surface of the conductive grid to the drive backplane is less than or equal to a distance from the lower surface of the micro light-emitting diode to the drive backplane. A distance from the upper surface of the conductive grid to the drive backplane is greater than or equal to a distance from the upper surface of the micro light-emitting diode to the drive backplane.

In a possible implementation, a height of the conductive grid in the direction perpendicular to the drive backplane is 1 to 2 times the height of the micro light-emitting diode, to block the light of the micro light-emitting diode, and avoid light crosstalk between different micro light-emitting diodes.

In a possible implementation, the display module further includes a lens layer. The lens layer is disposed on the transparent conductive layer. The lens layer may include a plurality of lenses. The plurality of lenses are in a one-to-one correspondence with the plurality of micro light-emitting diodes. The lens is configured to collimate light emitted by the micro light-emitting diode, to improve luminance and image quality of the display module.

According to a second aspect, an embodiment of this application further provides a display module preparation method. The method includes: forming a plurality of micro light-emitting diodes on a drive backplane, where the micro light-emitting diode includes a first electrode and a second electrode that are disposed opposite to each other, the drive backplane includes a plurality of first electrode contacts and a second electrode contact, the plurality of micro light-emitting diodes are in a one-to-one correspondence with the plurality of first electrode contacts, and first electrode of the micro light-emitting diode is in contact with the first electrode contact corresponding to the micro light-emitting diode; forming a common electrode and a conductive grid on the drive backplane, where the common electrode is electrically connected to the second electrode contact, the conductive grid is electrically connected to the common electrode, the conductive grid includes a plurality of grids, the micro light-emitting diode corresponds to the grid, and the micro light-emitting diode is located in a region defined by the grid corresponding to the micro light-emitting diode; and forming a transparent conductive layer, where the transparent conductive layer covers the plurality of micro light-emitting diodes and the conductive grid, and the second electrode of the micro light-emitting diode is electrically connected to the conductive grid through the transparent conductive layer.

In a possible implementation, before forming the common electrode and the conductive grid on the drive backplane, the method further includes: forming a height control layer on the drive backplane, and making an upper surface of the micro light-emitting diode flush with an upper surface of the height control layer.

In a possible implementation, forming the height control layer on the drive backplane, and making the upper surface of the micro light-emitting diode flush with the upper surface of the height control layer include: forming a first dielectric filling layer on a surface of a wafer obtained after the micro light-emitting diode is formed; forming the height control layer on the first dielectric filling layer; forming a second dielectric filling layer on the height control layer; and flattening the wafer obtained after the second dielectric filling layer is formed, to stop a surface height of the wafer at a surface of the height control layer, and make the upper surface of the micro light-emitting diode flush with the upper surface of the height control layer, where a material of the height control layer has a different removal rate from a material of the micro light-emitting diode, a material of the first dielectric filling layer, and a material of the second dielectric filling layer.

In a possible implementation, forming the common electrode and the conductive grid on the drive backplane, and making the conductive grid in contact with the common electrode include: forming a grid-shaped trench and a common electrode groove on the surface of the wafer obtained after the height control layer is formed, where the grid-shaped trench communicates with the common electrode groove; and forming the conductive grid in the grid-shaped trench, and forming the common electrode in the common electrode groove. In this way, the conductive grid is electrically connected to the common electrode. A current from the micro light-emitting diode may be transmitted to the conductive grid through the transparent conductive layer, and then transmitted to the common electrode through the conductive grid, to reduce a resistance of a current loop of the micro light-emitting diode, and avoid impact of a voltage drop caused by an excessively high resistance on display quality.

According to a third aspect, an electronic device is further provided, including a housing and the display module provided in any implementation of the first aspect, where the display module is mounted on the housing.

### BRIEF DESCRIPTION OF DRAWINGS

FIG. 1 is a diagram of an electronic device according to an embodiment of this application;
FIG. 2 is a diagram of a display module according to an embodiment of this application;
FIG. 3 is a sectional view of a display module according to an embodiment of this application;
FIG. 4 is a diagram of another display module according to an embodiment of this application;
FIG. 5 is a sectional view of another display module according to an embodiment of this application;
FIG. 6 is a diagram of a working principle of a display module according to an embodiment of this application;
FIG. 7 is a diagram of a working principle of another display module according to an embodiment of this application;
FIG. 8 is a sectional view of another display module according to an embodiment of this application;
FIG. 9 is a diagram of light crosstalk according to an embodiment of this application;
FIG. 10 is a diagram of a principle of preventing light crosstalk according to an embodiment of this application;
FIG. 11 is a diagram of a grid shape of a conductive grid according to an embodiment of this application;
FIG. 12 is a diagram of a shape of a metal grid according to an embodiment of this application;
FIG. 13 is a diagram of another display module according to an embodiment of this application;
FIG. 14 is a sectional view of another display module according to an embodiment of this application;
FIG. 15 is a sectional view of another display module according to an embodiment of this application;
FIG. 16 is a schematic flowchart of a display module preparation method according to an embodiment of this application;
FIG. 17 is a schematic flowchart of another display module preparation method according to an embodiment of this application;
FIG. 18 is a schematic flowchart of another display module preparation method according to an embodiment of this application; and
FIG. 19 to FIG. 21 are process flowcharts of a display module preparation method according to an embodiment of this application.

### DESCRIPTION OF EMBODIMENTS

The following describes the technical solutions in embodiments of this application with reference to the accompanying drawings in embodiments of this application. In this application, "at least one" means one or more, and "a plurality of" means two or more. The term "and/or" describes an association relationship between associated objects and indicates that three relationships may exist. For example, A and/or B may indicate the following three cases: Only A exists, both A and B exist, and only B exists, where A and B may be singular or plural. "At least one of the following items (pieces)" or a similar expression thereof indicates any combination of these items, including a single item (piece) or any combination of a plurality of items (pieces). For example, at least one item (piece) of a, b, or c may indicate: a, b, c, a and b, a and c, b and c, or a, b, and c, where a, b, and c may be singular or plural.

In embodiments of this application, terms such as "first" and "second" are used to distinguish between objects with similar names, functions, or effects. A person skilled in the art may understand that the terms such as "first" and "second" do not limit a quantity and an execution sequence. The term "coupling" indicates an electrical connection, including a direct connection through a wire or a connection end or an indirect connection through another component. Therefore, "coupling" should be considered as a generalized electronic communication connection.

It should be noted that in this application, term such as "example" or "for example" indicates giving an example, an illustration, or a description. Any embodiment or design scheme described as an "example" or "for example" in this application should not be explained as being more preferred or having more advantages than another embodiment or design scheme. To be precise, use of the terms such as "example" or "for example" is intended to present a related concept in a specific manner.

The solutions provided in embodiments of this application may be applied to an electronic device, for example, a mobile phone (mobile phone), a personal computer (personal computer, PC), a tablet computer (pad), an intelligent wearable product (for example, a smart watch or a smart band), a virtual reality (virtual reality, VR) terminal device, an augmented reality (augmented reality, AR) terminal device, a vehicle-mounted terminal, or a display, or any electronic device that needs to be configured with a display module. A specific form of the electronic device is not specially limited in embodiments of this application.

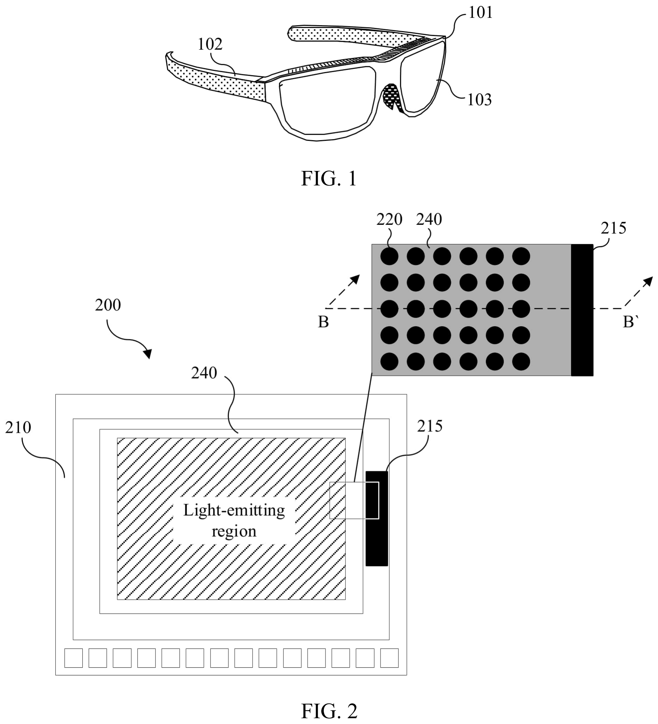

For example, the electronic device is an AR head-mounted display device. The AR head-mounted display device may include AR glasses, an AR helmet, or the like. For ease of description, FIG. 1 is a diagram of the AR glasses according to an embodiment of this application.

The AR glasses include a rim 101, a temple 102, and a lens 103. The lens 103 is mounted in the rim 101. The temple 102 is connected to the rim 101. The temple 102 and the rim 101 may make the AR glasses be worn in front of eyes of a user. A display screen is disposed in the temple 102, and may display an image or other content. The lens 103 is an optical waveguide lens. The image or the other content displayed on the display screen may be transmitted to the lens 103 through an optical waveguide for display, and is imaged in front of the eyes of the user.

Because a space size of the AR glasses is limited, the display screen may be a micro light-emitting diode (micro light-emitting diode, Micro LED) display screen. A micro LED is a micron-level display component, and a size of the micro LED usually ranges from 0.1 micrometer to 100 micrometers. Miniaturization makes the micro LED have higher light-emitting luminance, resolution, and color saturation, a faster display response speed, and lower power consumption. Emergence of a micro LED display technology makes it possible to achieve miniaturization and high resolution of devices such as an AR display device, a VR display device, a near-eye display (near-eye display, NED), and a head-up display (head-up display, HUD) device.

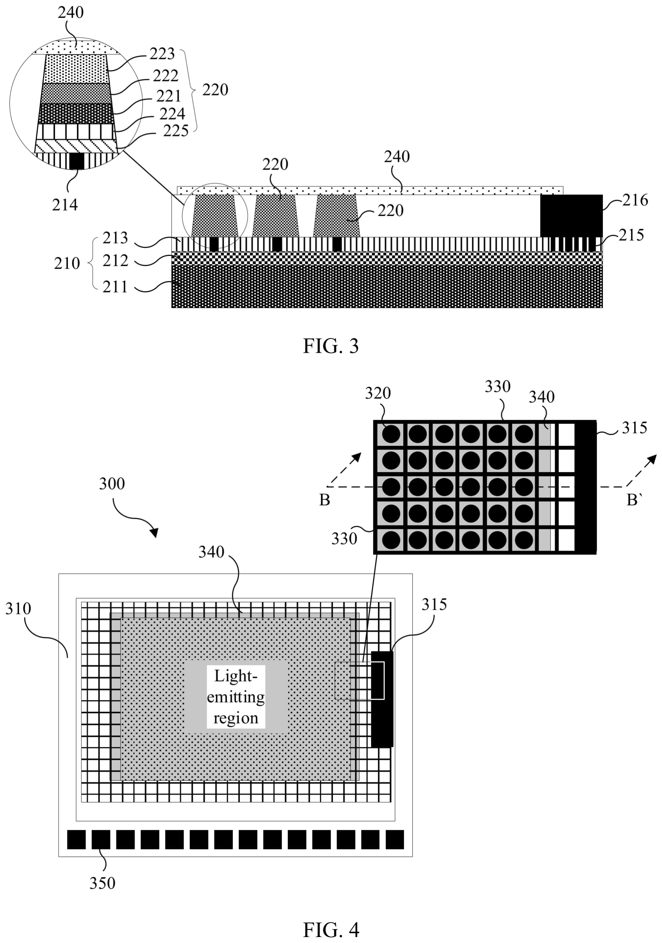

With reference to FIG. 2 and FIG. 3, FIG. 2 is a diagram of a display module 200 according to an embodiment of this application, and FIG. 3 is a sectional view of the display module 200 along a B-B' direction in FIG. 2 according to an embodiment of this application.

The display module 200 includes a drive backplane 210. The drive backplane 210 may include a substrate 211, a drive line layer 212, and a protection layer 213 that are sequentially disposed. The drive line layer 212 may include a plurality of drive circuits or drive units configured to control the Micro LED to perform active driving. The drive circuit may usually include elements such as a transistor, a capacitor, and a resistor. A second electrode contact 215 and a plurality of first electrode contacts 214 are disposed on a surface of the protection layer 213. The first electrode contact 214 and the second electrode contact 215 are connected to the drive circuit through vias in the protection layer 213. For example, the first electrode contact 214 may be an anode contact, and the second electrode contact 215 may be a cathode contact.

The drive backplane 210 may be divided into a light-emitting region and a peripheral region outside the light-emitting region. The light-emitting region may be provided with a plurality of pixel units arranged in an array. Each pixel unit includes one or more subpixels. Each subpixel may include a micro light-emitting diode 220. In some possible implementations, the pixel unit may include a red subpixel, a green subpixel, and a blue subpixel, so that color display can be achieved through mixing of red, green, and blue. Certainly, during actual application, a light-emitting color of the subpixel in the pixel unit may be designed and determined based on an actual application environment. This is not limited herein.

Refer to FIG. 3. The micro light-emitting diode 220 includes a first semiconductor layer 221, a light-emitting layer 222, and a second semiconductor layer 223 that are sequentially stacked. The first semiconductor layer 221 is located on a side close to the drive backplane 210, and the second semiconductor layer 223 is located on a side facing away from the drive backplane 210. P-type doping or N-type doping may be performed on a semiconductor material (for example, a material such as gallium oxide) of the first semiconductor layer 221, so that the first semiconductor layer 221 can provide holes or electrons. The light-emitting layer 222 may use a multi-quantum well layer to improve light-emitting efficiency. N-type doping or P-type doping may be performed on a semiconductor material (for example, a material such as gallium nitride) of the second semiconductor layer 223, so that the second semiconductor layer 223 can provide the electrons or the holes. The first semiconductor layer 221 and the second semiconductor layer 223 are located on two sides of the light-emitting layer 222, and doping types of the two semiconductor layers are opposite. If N-type doping is performed on the first semiconductor layer 221, P-type doping is performed on the second semiconductor layer 223; or if P-type doping is performed on the first semiconductor layer 221, N-type doping is performed on the second semiconductor layer 223. During specific implementation, both the foregoing two structures may be used.

The micro light-emitting diode 220 may further include an ohmic contact layer 224 in contact with the first semiconductor layer 221. The ohmic contact layer 224 may form a first electrode of the micro light-emitting diode 220. The micro light-emitting diode 220 further includes a second electrode opposite to the first electrode. In some possible implementations, a conductive contact layer may be disposed on the second semiconductor layer 223 as the second electrode. Alternatively, in this embodiment of this application, a transparent conductive layer 240 in contact with the second semiconductor layer 223 may be used as the second electrode of the micro light-emitting diode 220, and a plurality of micro light-emitting diodes 220 may share a same second electrode. In some possible implementations, a bonding layer 225 is further disposed between the ohmic contact layer 224 and the drive backplane 210, and the bonding layer 225 is configured to bond the micro light-emitting diode 220 to the drive backplane 210. For example, in this embodiment of this application, the first semiconductor layer 221 uses P-type doping, and the second semiconductor layer 223 uses N-type doping. In this case, the first electrode of the micro light-emitting diode 220 may be an anode, and the second electrode of the micro light-emitting diode 220 may be a cathode.

The plurality of first electrode contacts 214 are disposed in the light-emitting region in a distributed manner. The second electrode contact 215 is disposed in the peripheral region. A common electrode 216 is further disposed on the drive backplane 210. A position of the common electrode 216 corresponds to the second electrode contact 215, and is electrically connected to the second electrode contact 215. The plurality of first electrode contacts 214 are in a one-to-one correspondence with the plurality of micro light-emitting diodes 220. A first electrode of each micro light-emitting diode 220 is in contact with the first electrode contact 214 corresponding to the micro light-emitting diode 220, to form an electrical connection. The plurality of micro light-emitting diodes 220 are electrically connected to the common electrode 216 through the second electrode shared by the micro light-emitting diodes 220, to electrically connect to the second electrode contact 215. In this way, the micro light-emitting diode 220 is electrically connected to the first electrode contact 214 and the second electrode contact 215 to form a drive loop.

For example, the transparent conductive layer 240 covers the plurality of micro light-emitting diodes 220 in the light-emitting region, and the second semiconductor layer 223 of the micro light-emitting diode 220 is electrically connected to the transparent conductive layer 240. The transparent conductive layer 240 may form a common second electrode of the plurality of micro light-emitting diodes 220, or it may be considered that a part of the transparent conductive layer 240 in contact with each micro light-emitting diode forms the second electrode of the micro light-emitting diode. The common electrode 216 is disposed in the peripheral region of the drive backplane 210. For example, the common electrode 216 may be disposed on the second electrode contact 215, and the common electrode 216 is electrically connected to the second electrode contact 215. The transparent conductive layer 240 may be connected to the common electrode 216 in the peripheral region. For example, the transparent conductive layer 240 may cover both the plurality of micro light-emitting diodes in the light-emitting region and the common electrode in the peripheral region. A current may flow from the first electrode contact 214 of the drive backplane 210 to the first electrode of the micro light-emitting diode 220, flow out of the second electrode of the micro light-emitting diode 220 after passing through the micro light-emitting diode, pass through the transparent conductive layer 240 to the common electrode 216, and finally reach the second electrode contact 215, to form the drive loop. The micro light-emitting diode 220 may emit light for display when the current flows through the micro light-emitting diode 220. Grayscale, luminance, and the like displayed by the micro light-emitting diode 220 may be adjusted by adjusting a magnitude and turn-on time of the current flowing through the micro light-emitting diode 220.

Considering light-emitting effect, the transparent conductive layer 240 may be made of a material with high visible light transmittance, for example, indium tin oxide (ITO). The material with the high visible light transmittance usually has a high resistance value. A current from the second electrode of the micro light-emitting diode 220 is transmitted to the common electrode 216 through the transparent conductive layer 240, and a material (for example, ITO) of the transparent conductive layer 240 has a high resistance value. In addition, path lengths for the current from the micro light-emitting diodes 220 at different positions to the common electrode 216 vary. For example, refer to FIG. 3. FIG. 3 is a sectional view along the B-B' direction in FIG. 2. A current path between a micro light-emitting diode 220 close to the common electrode 216 and the common electrode 216 is short, and a current path between a micro light-emitting diode 220 away from the common electrode 216 and the common electrode 216 is long. Path lengths of current loops of the micro light-emitting diode 220 at different positions vary, and the transparent conductive layer 240 has high resistivity. This leads to a specific degree of a voltage drop (IR drop). Because a micro LED display panel uses a current to drive the micro light-emitting diode to emit light, and the micro light-emitting diode is sensitive to a slight change in current, a small change in current causes a great change in luminance. The current path between the micro light-emitting diode close to the common electrode 216 and the common electrode 216 is short, a resistance is low, and a voltage drop is small as well. Therefore, display luminance of these micro light-emitting diodes is slightly affected. However, the current path between the micro light-emitting diode away from the common electrode 216 and the common electrode 216 is long, a resistance is high, and a voltage drop is large as well, resulting in lower display luminance. This causes luminance differences among the micro light-emitting diodes at different positions.

The current loops of the micro light-emitting diodes at different positions vary in path lengths when flowing through the transparent conductive layer, and the material of the transparent conductive layer has high resistivity. Therefore, a current loop flowing through a long path in the transparent conductive layer has a high resistance, and a current loop flowing through a short path in the transparent conductive layer has a low resistance. A difference in resistances causes a difference in current magnitude in different loops, and finally causes a display luminance difference.

To resolve the foregoing problem, an embodiment of this application provides another display module. A conductive grid is disposed on a drive backplane. A current from each pixel does not flow through a transparent conductive layer to a common electrode, but may flow through the transparent conductive layer to the conductive grid, and then flow through the conductive grid to a second electrode contact, forming a loop. A resistance of the conductive grid is lower than that of a material of the transparent conductive layer. Such a solution is equivalent to replacing the high-resistivity material of the transparent conductive layer in the current loop of the micro light-emitting diode with a material of a conductive grid. This can reduce a resistance of the current loop of the micro light-emitting diode, and avoid an IR drop that affects image quality.

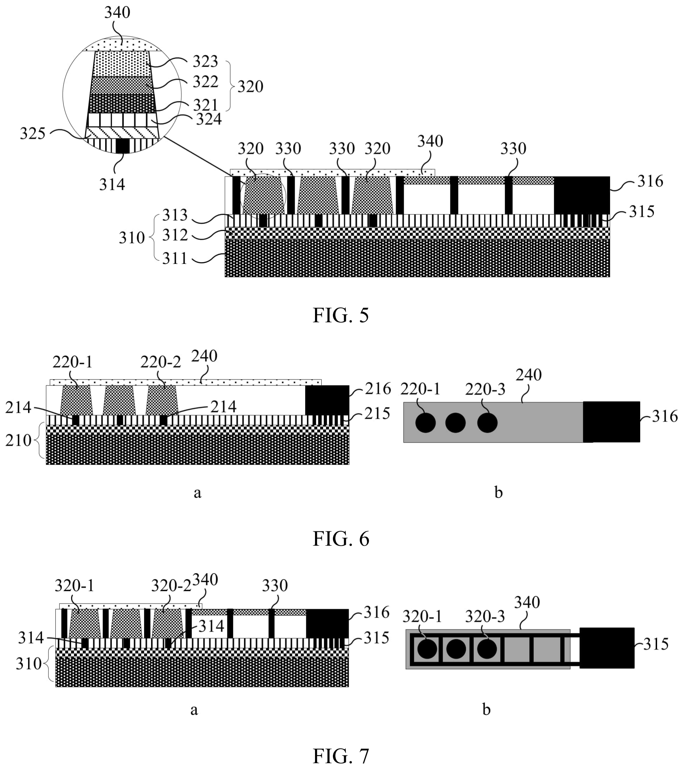

Refer to FIG. 4 and FIG. 5. FIG. 4 is a diagram of a structure of a display module 300 according to an embodiment of this application. FIG. 5 is a sectional view along a B-B' direction in FIG. 4. The display module 300 includes a drive backplane 310, and a conductive grid 330, a transparent conductive layer 340, and a plurality of micro light-emitting diodes 320 that are disposed on the drive backplane 310. The drive backplane 310 includes a light-emitting region and a peripheral region outside the light-emitting region. A plurality of first electrode contacts 314 are disposed in the light-emitting region, and a second electrode contact 315 is disposed in the peripheral region. A common electrode 316 electrically connected to the second electrode contact 315 is further disposed on the drive backplane. The plurality of micro light-emitting diodes 320 are arranged in the light-emitting region. The plurality of micro light-emitting diodes 320 are in a one-to-one correspondence with the plurality of electrode contacts 314. The micro light-emitting diode 320 includes a first electrode and a second electrode. In this embodiment, the first electrode is an electrode facing the drive backplane 310. The second electrode is an electrode away from the drive backplane 310. The first electrode of the micro light-emitting diode 320 is in contact with the electrode contact 314 corresponding to the micro light-emitting diode 320, to form an electrical connection.

The conductive grid 330 is disposed on the drive backplane 310. The conductive grid 330 is a grid formed by intersecting and connecting a plurality of conductive grid lines. The conductive grid 330 includes a plurality of grids. The micro light-emitting diode 320 corresponds to the grid. The micro light-emitting diode 320 may be disposed in a region of the drive backplane 310 defined by the grid. The conductive grid 330 located in the peripheral region is in contact with and electrically connected to the common electrode 316.

The transparent conductive layer 340 covers the conductive grid 330 located in the light-emitting region. The transparent conductive layer 340 is electrically connected to the conductive grid 330. The second electrode of the micro light-emitting diode 320 is in contact with the transparent conductive layer 340 (or it may be considered that a part of the transparent conductive layer 340 in contact with the micro light-emitting diode forms the second electrode of the micro light-emitting diode 320). A projection of the transparent conductive layer 340 onto the drive backplane 310 covers the light-emitting region. In this way, it can be ensured that the transparent conductive layer 340 is electrically connected to all the micro light-emitting diodes 320. In addition, the transparent conductive layer 340 is electrically connected to the conductive grid 330. In other words, in this embodiment of this application, the conductive grid 330 is electrically connected to the common electrode 316, and the second electrode of the micro light-emitting diode 220 may be electrically connected to the conductive grid 330 through the transparent conductive layer 340, that is, electrically connected to the common electrode 316.

In some embodiments, the drive backplane 310 may include a substrate 311, a drive line layer 312, and a protection layer 313 that are sequentially disposed. The drive line layer 312 may include a plurality of drive circuits or drive units configured to control the micro LED to perform active driving. The drive circuit may usually include a complementary metal-oxide-semiconductor (complementary metal-oxide-semiconductor, CMOS) device, a TFT device, or the like. The plurality of first electrode contacts 314 and the second electrode contact 315 are disposed on a surface of the protection layer 313. The first electrode contact 314 and the second electrode contact 315 are connected to the drive line layer 312 through vias in the protection layer 313. For example, the first electrode contact 314 may be an anode contact, and the second electrode contact 315 may be a cathode contact. The drive backplane 310 is further provided with the common electrode 316 at a position corresponding to the second electrode contact 315. The common electrode 316 is electrically connected to the second electrode contact. A material of the substrate 311 may be a semiconductor material such as silicon, silicon carbide, gallium nitride, germanium, gallium arsenide, or indium phosphate, or may be a non-conductive material such as glass, plastic, or sapphire wafer.

The drive backplane 310 may provide a drive current for each micro light-emitting diode 320. The current flows from the first electrode contact 314 of the drive backplane 310 to the first electrode of the micro light-emitting diode 320, flows out of the second electrode of the micro light-emitting diode 320, and finally reaches the second electrode contact 315 on the drive backplane 310, forming a loop.

In a possible implementation, with reference to FIG. 4, a plurality of pads 350 are further disposed on the drive backplane 310. Some of the pads 350 are electrically connected to the drive circuit in the drive line layer 312, to provide a power signal, a data signal, and the like for the drive circuit. The other pads 350 may be electrically connected to the second electrode contact 315 on the drive backplane 310. The first electrode of the micro light-emitting diode 320 is electrically connected to the first electrode contact 314 on the drive backplane 310, that is, electrically connected to the drive circuit in the drive line layer 312. The second electrode of the micro light-emitting diode 320 is electrically connected to the common electrode 316, that is, electrically connected to the second electrode contact 315. In a possible implementation, the second electrode contact 315 may be a cathode, and the first electrode contact 314 may be an anode. When the micro light-emitting diode 320 forms the loop with the first electrode contact 314 and the common electrode 316 (or the second electrode contact 315), a cathode current may be injected from the common electrode 316 (or the second electrode contact 315) into the micro light-emitting diode 320, and recombine with a carrier injected from the first electrode contact 314 into the micro light-emitting diode 320 to emit light.

In this embodiment of this application, the conductive grid 330 is disposed on the drive backplane 310, the second electrode of the micro light-emitting diode 320 is electrically connected to the conductive grid 330 through the transparent conductive layer 340, and the conductive grid 330 is electrically connected to the common electrode 316. Therefore, after flowing out of the second electrode of the micro light-emitting diode 320 into the transparent conductive layer 340, a current may choose to flow through the conductive grid 330 with a lower resistance to the common electrode 316, forming the loop. The conductive grid 330 has good conductivity and a low resistance. In this way, a problem such as an IR drop caused by a high resistance of the transparent conductive layer 340 can be overcome.

With reference to FIG. 6 and FIG. 7, FIG. 6 is a diagram of a display module, and FIG. 7 is a diagram of another display module. FIG. 6 shows a micro light-emitting diode 220-1 and a micro light-emitting diode 220-2. The micro light-emitting diode 220-1 is far away from a common electrode 216, and the micro light-emitting diode 220-2 is close to the common electrode 216. FIG. 7 shows a micro light-emitting diode 320-1 and a micro light-emitting diode 320-2. The micro light-emitting diode 320-1 is far away from a common electrode 316, and the micro light-emitting diode 320-2 is close to the common electrode 316.

When no conductive grid is disposed, for example, with reference to figure a and figure b in FIG. 6, a path of a current loop of the micro light-emitting diodes (220-1 and 220-2) are as follows: A current flows through a first electrode contact 214 to a first electrode of the micro light-emitting diodes (220-1 and 220-2), flows out of a second electrode of the micro light-emitting diodes (220-1 and 220-2) to a transparent conductive layer 240, and flows through the transparent conductive layer 240 to the common electrode 216, forming a loop.

When a conductive grid is disposed, with reference to figure a and figure b in FIG. 7, a path of a current loop of the micro light-emitting diodes (320-1 and 320-2) is as follows: A current flows through a first electrode contact 314 to a first electrode of the micro light-emitting diodes (320-1 and 320-2), flows out of a second electrode of the micro light-emitting diodes (320-1 and 320-2) to a transparent conductive layer 340, flows through the transparent conductive layer 340 to the nearest conductive grid 330, and flows through the conductive grid 330 to the common electrode 316, forming a loop.

It can be learned that, with reference to FIG. 6, when no conductive grid is disposed, the transparent conductive layer occupies a large part in a current path of the micro light-emitting diode, and therefore, a resistance of the loop is high. After the conductive grid is disposed, the transparent conductive layer occupies only a small part in a current path of the micro light-emitting diode, the conductive grid occupies a large part, and therefore, a resistance is low, so that a problem such as display quality degradation caused by an IR drop can be avoided.

In addition, for the micro light-emitting diode 320-1 and the micro light-emitting diode 320-2 at different positions, although a distance from the micro light-emitting diode 320-1 to the common electrode 316 is different from a distance from the micro light-emitting diode 320-2 to the common electrode 316, and current paths of the micro light-emitting diode 320-1 and the micro light-emitting diode 320-2 have different lengths, which is mainly reflected in a part occupied by the conductive grid, the conductive grid is made of a conductive metal material with a low resistance, and therefore, such a difference does not cause an obvious change in the resistance. When grid pitch of the conductive grid is close, for the micro light-emitting diode 320-1 and the micro light-emitting diode 320-2 at different positions, parts occupied by the transparent conductive layer 340 in the current paths of the micro light-emitting diode 320-1 and the micro light-emitting diode 320-2 are close, that is, distances from the second electrode of the micro light-emitting diode to the nearest conductive grid, so that resistances of current loops of the micro light-emitting diodes at different positions is approximate, thereby avoiding display luminance difference.

In some embodiments of this application, resistivity of a material of the conductive grid is lower than resistivity of a material of the transparent conductive layer. For example, the conductive grid may be made of the conductive metal material, for example, may include a single-layer metal, a stacked metal or medium, and a stacked structure of a metal, such as copper (Cu), aluminum (Al), tungsten (W), titanium nitride (TiN), tantalum nitride (TaN), titanium-tungsten alloy (TiW), a stacked structure of titanium-tungsten alloy-aluminum-titanium-tungsten alloy (TiW/Al/TiW), a stacked structure of titanium nitride-aluminum-titanium nitride (TiN/Al/TiN), a stacked structure of titanium-tungsten alloy-aluminium-titanium nitride (TiW/Al/TiN), or a stacked structure of titanium-tungsten alloy-tungsten-titanium nitride (TiW/W/TiN).

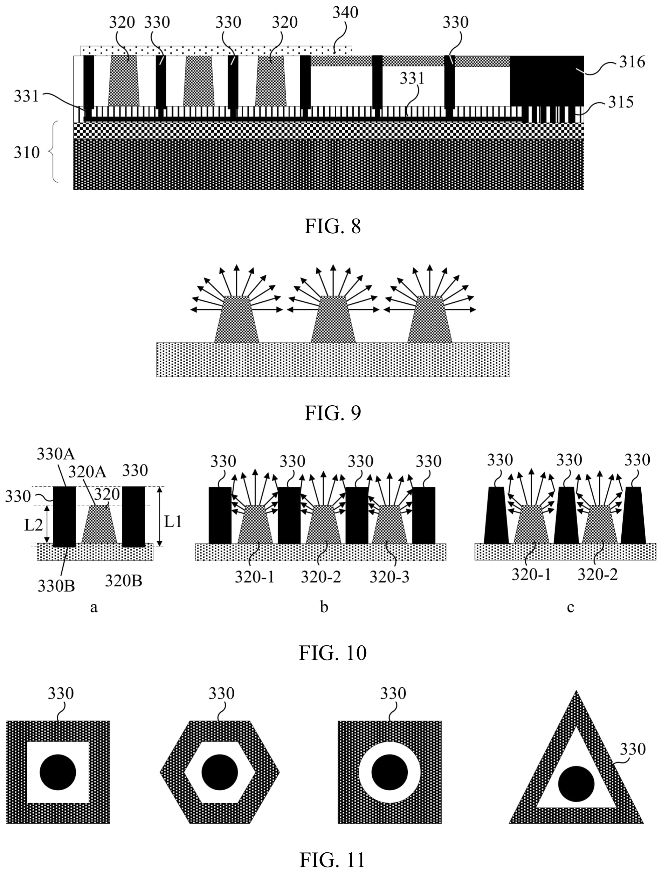

In some embodiments of this application, the conductive grid 330 may be disposed on a drive backplane 310, and is electrically connected to the common electrode 316. The conductive grid 330 is electrically connected to a second electrode contact 315 through the common electrode 316. For example, refer to FIG. 8. In some other possible implementations of this application, the conductive grid 330 may be electrically connected to the second electrode contact 315 through an internal routing of the drive backplane 310. In addition, in some other implementations of this application, the conductive grid 330 may alternatively be electrically connected to the second electrode contact 315 in another manner, to reduce a voltage drop generated by the transparent conductive layer in a drive loop of the micro light-emitting diode.

Because the micro LED is a self-luminous device, and a light-emitting shape of the micro LED is Lambertian. As shown in FIG. 9, luminance of light emitted by the micro LED in all directions is the same. This causes optical crosstalk between pixels. To avoid this problem, in this embodiment of this application, a light-emitting direction of each micro light-emitting diode may be defined by the conductive grid, to avoid the optical crosstalk between the pixels.

In some embodiments of this application, the conductive grid may be an opaque conductive grid. With reference to FIG. 10, a height of the conductive grid in a direction perpendicular to the drive backplane is not less than a height of the micro light-emitting diode. For example, with reference to figure a in FIG. 10, the conductive grid 330 and the micro light-emitting diode 320 each include an upper surface and a lower surface. The lower surface 330B of the conductive grid 330 is not higher than the lower surface 320B of the micro light-emitting diode 320. In other words, a distance from the lower surface 330B of the conductive grid 330 to the drive backplane 310 is less than or equal to a distance from the lower surface 320B of the micro light-emitting diode 320 to the drive backplane 310. The upper surface 330A of the conductive grid 330 is not lower than the upper surface 320A of the micro light-emitting diode 320. In other words, a distance from the upper surface 330A of the conductive grid 330 to the drive backplane 310 is greater than or equal to a distance from the upper surface of the micro light-emitting diode 320 to the drive backplane 310. In other words, a lowest point of the conductive grid 330 in the direction perpendicular to the drive backplane is not higher than a lowest point of the micro light-emitting diode 320, and a highest point of the conductive grid 330 in the direction perpendicular to the drive backplane is not lower than a highest point of the micro light-emitting diode 320. With reference to figure b in FIG. 10, in this arrangement manner, the conductive grid 330 may be used to block light emitted by the micro light-emitting diode 320 from scattering to adjacent micro light-emitting diodes 320, to avoid the optical crosstalk between different pixels.

In some embodiments of this application, a height L1 of the conductive grid 330 is not less than a height L2 of the micro light-emitting diode 320, and the lowest point of the conductive grid 330 in the direction perpendicular to the drive backplane is lower than the lowest point of the micro light-emitting diode 320, so that crosstalk caused by leakage of the light emitted by the micro light-emitting diode 320 from the bottom of the micro light-emitting diode 320 can be avoided. The highest point of the conductive grid 330 that is perpendicular to the drive backplane is higher than the highest point of the micro light-emitting diode 320, so that crosstalk of light on the top of the micro light-emitting diode 320 can be avoided in a horizontal direction.

In addition, with reference to figure b in FIG. 10, the conductive grid 330 may further have specific reflective effect on the light emitted by the micro light-emitting diode 320, which may converge and/or collimate the light emitted by the micro light-emitting diode 320, thereby improving overall light-emitting luminance of the display module.

In some embodiments of this application, the height L1 of the conductive grid 330 in the direction perpendicular to the drive backplane is 1 to 2 times the height L2 of the micro light-emitting diode 320. When the height L1 of the conductive grid 330 is the same as the height L2 of the micro light-emitting diode 320, to ensure anti-crosstalk effect, the upper surface 330A of the conductive grid 330 needs to be flush with the upper surface 320A of the micro light-emitting diode 320, and the lower surface 330B of the conductive grid 330 needs to be flush with the lower surface 320B of the micro light-emitting diode 320.

In some embodiments of this application, the conductive grid is a conductive grid formed by intersecting a plurality of grid lines. The conductive grid includes a plurality of grids. One or more micro light-emitting diodes may be disposed in a region of the drive backplane defined by each grid. Herein, one micro light-emitting diode and a plurality of micro light-emitting diodes both refer to a minimum unit of an LED pixel. For example, in some cases, the display module is a monochrome display module, and one micro light-emitting diode may form one pixel. In this case, one micro light-emitting diode may be disposed in the region defined by the grid of the conductive grid, and the micro light-emitting diode is connected to the conductive grid through the transparent conductive layer. In some other cases, the display module is a color display module, and the plurality of micro light-emitting diodes are combined to form one pixel. In this case, a plurality of micro light-emitting diodes may be disposed in the region defined by the grid of the conductive grid, and these micro light-emitting diodes are electrically connected to the conductive grid through the transparent conductive layer. For example, if one pixel includes two red subpixels, one green subpixel, and one blue subpixel, four micro light-emitting diodes, namely, two red micro light-emitting diodes, one blue micro light-emitting diode, and one green micro light-emitting diode, may be disposed in a grid aperture of the conductive grid.

In some embodiments of this application, the conductive grid includes a plurality of grid apertures. As shown in figure b in FIG. 10, a side wall of the grid aperture may be perpendicular to the drive backplane. Alternatively, as shown in figure c in FIG. 10, a side wall of the grid may form an included angle with the drive backplane. For example, the side wall of the grid aperture and the drive backplane are disposed at an obtuse angle. In this way, the light emitted by the micro light-emitting diode may be reflected on an inner wall of the grid aperture for a plurality of times, and after a plurality of reflections, finally exit through an opening of the grid aperture, so that the optical crosstalk between the different pixels can be avoided, and light-emitting luminance can be improved.

In addition, refer to FIG. 11. A grid shape of the conductive grid may include a regular shape or an irregular shape, for example, a triangle, a quadrilateral, a hexagon, an octagon, or a circle, and may be specifically adjusted based on different arrangement manners of the micro light-emitting diodes.

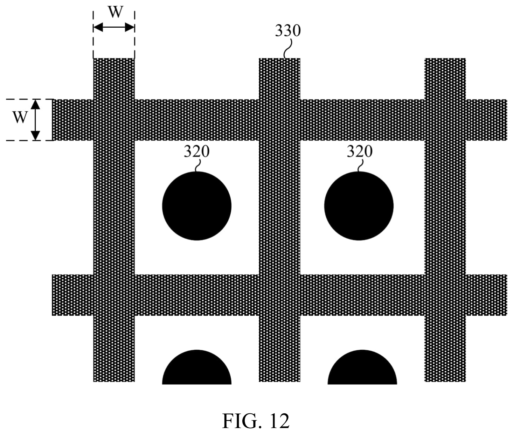

With reference to FIG. 12, the conductive grid 330 may be a conductive grid formed by intersecting a plurality of conductive metal lines. In this embodiment of this application, a width W of a grid line of the conductive grid 330 ranges from 10 nm to 1000 nm. In the micro LED, a distance (pitch) between two adjacent micro light-emitting diodes is fixed, and a larger area of the micro light-emitting diode indicates higher light-emitting luminance. Therefore, in this case, a larger size of a single micro light-emitting diode indicates a smaller distance between boundaries of the two adjacent micro light-emitting diodes, and the conductive grid with a small size can be disposed. In this embodiment of this application, the width W of the grid line of the conductive grid may be 500 nm.

In some embodiments, with reference to FIG. 5, the micro light-emitting diode 320 includes an ohmic contact layer 324, a first semiconductor layer 321, a light-emitting layer 322, and a second semiconductor layer 323 that are sequentially stacked. The first semiconductor layer 321 is located on a side close to the drive backplane 310, and the second semiconductor layer 323 is located on a side facing away from the drive backplane 310. In some embodiments of this application, a bonding layer 325 is further disposed between the first semiconductor layer 321 and the drive backplane 310, and the micro light-emitting diode 320 may be adhered or bonded to the drive backplane 310 through the bonding layer 325.

P-type doping or N-type doping may be performed on a semiconductor material (for example, a material such as gallium nitride) of the first semiconductor layer 321, so that the first semiconductor layer 321 can provide holes or electrons. N-type doping or P-type doping may be performed on a semiconductor material (for example, a material such as gallium nitride) of the second semiconductor layer 323, so that the second semiconductor layer 323 can provide the electrons or the holes.

In the direction perpendicular to the drive backplane 310, the first semiconductor layer 321 and the second semiconductor layer 323 are located on two sides of the light-emitting layer 322, and doping types of the two semiconductor layers are opposite. If N-type doping is performed on the first semiconductor layer 321, P-type doping is performed on the second semiconductor layer 323; or if P-type doping is performed on the first semiconductor layer 321, N-type doping is performed on the second semiconductor layer 323.

The micro light-emitting diode 320 may further include the ohmic contact layer 324 in contact with the first semiconductor layer 321. The ohmic contact layer 324 may improve electrical conductivity between the first semiconductor layer 321 and the drive backplane 310. In addition, in this embodiment of this application, the ohmic contact layer 324 may form a first electrode of the micro light-emitting diode 320. The micro light-emitting diode 320 further includes the second electrode opposite to the first electrode. In a possible implementation, a conductive contact layer (not shown in the figure) may be disposed on the second semiconductor layer 323 as the second electrode of the micro light-emitting diode 320. Alternatively, in this embodiment of this application, the transparent conductive layer 340 in contact with the second semiconductor layer 323 may be used as the second electrode of the micro light-emitting diode 320, and the plurality of micro light-emitting diodes 320 may share a same second electrode.

In some embodiments of this application, the bonding layer 325 is further disposed between the ohmic contact layer 324 and the drive backplane 310, and the bonding layer 325 is configured to bond the micro light-emitting diode 320 to the drive backplane 310.

In this embodiment of this application, for example, the first semiconductor layer 321 uses P-type doping and the second semiconductor layer 323 uses N-type doping. On this basis, the first electrode of the micro light-emitting diode 320 may be an anode, and an anode voltage is applied to the first semiconductor layer 321. The second electrode of the micro light-emitting diode 320 may be a cathode, and a cathode voltage is applied to the second semiconductor layer 323.

In some cases, the micro light-emitting diode 320 is also referred to as a micro light-emitting diode mesa. A cross-sectional shape of each micro light-emitting diode 320 may be a trapezoidal structure. In other words, a side wall of the micro light-emitting diode 320 may be an inclined surface, and an angle between the side wall of the micro light-emitting diode 320 and the upper surface may be an obtuse angle, so that light convergence effect of the micro light-emitting diode can be improved. Alternatively, in some possible implementations, the micro light-emitting diode may be of a columnar structure. In this case, an included angle between the side wall of the micro light-emitting diode and the upper surface of the micro light-emitting diode is a right angle.

In some embodiments, a passivation layer may be disposed on the side wall of the micro light-emitting diode, to prevent the micro light-emitting diode from being damaged by etching in a preparation process. The passivation layer may be generally made of a material, for example, aluminum oxide or silicon oxide. A filling layer is disposed between adjacent micro light-emitting diodes and a surface of the drive backplane.

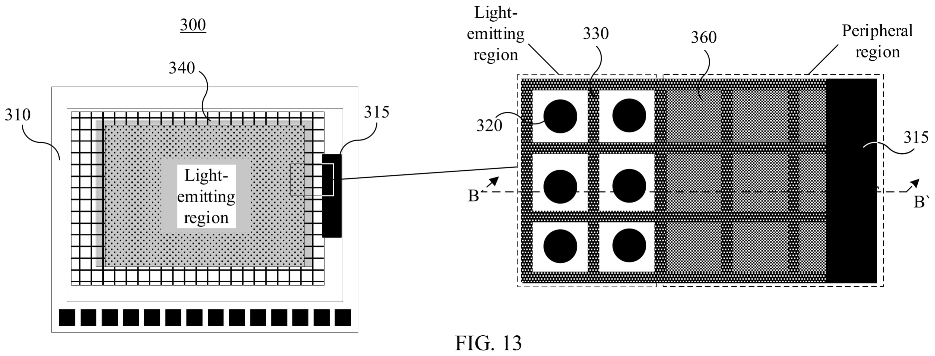

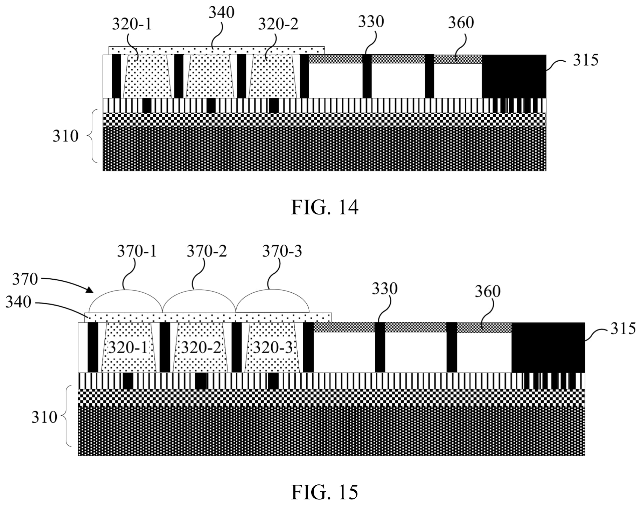

With reference to FIG. 13 and FIG. 14, FIG. 14 is a sectional view along a B-B' direction in FIG. 13. The conductive grid 330 is disposed in a light-emitting region and a peripheral region of the drive backplane 310. The micro light-emitting diode 320 is disposed in a grid aperture of the light-emitting region. A height control layer 360 is disposed in a grid aperture of the peripheral region. A material of the height control layer 360 has a different removal rate from a material of the micro light-emitting diode 320, a material of the filling layer, and the like. The height control layer 360 is configured to control a mesa height of the micro light-emitting diode 320. For example, the upper surface of the micro light-emitting diode 320 is flush with a height of an upper surface of the height control layer 360, or it may be considered that a distance from the upper surface of the height control layer to the surface of the drive backplane 310 is the height of the micro light-emitting diode 320.

In the display module 200 provided in this embodiment of this application, when no height control layer is disposed, the height of the micro light-emitting diode can be controlled only based on experience during flattening a surface of a wafer, and the mesa height cannot be precisely controlled during flattening. Excessive flatness may cause an excessively low height of the micro light-emitting diode. However, in the display module 300 provided in this embodiment of this application, the filling layer is disposed between the adjacent micro light-emitting diodes 320, the filling layer is disposed in the peripheral region outside the light-emitting region, and the height control layer 360 is disposed on the filling. In this way, when the surface of the wafer is flattened by using a process such as CMP, because the material of the height control layer 360 has a different removal rate from the material of the micro light-emitting diode 320, the material of the filling layer, and the like, a height of the wafer can stop at the upper surface of the height control layer 360 during flattening of the wafer, so that the height of the micro light-emitting diode 320 can be precisely controlled.

In some other possible implementations, refer to FIG. 15. The display module 300 further includes a lens layer 370. The lens layer 370 is disposed on the transparent conductive layer 340. The lens layer 370 includes a plurality of lenses. The plurality of lenses are in a one-to-one correspondence with the plurality of micro light-emitting diodes. For example, a lens 370-1 corresponds to the micro light-emitting diode 320-1, a lens 370-2 corresponds to the micro light-emitting diode 320-2, and a lens 370-3 corresponds to a micro light-emitting diode 320-3. In some embodiments of this application, a central axis of the lens and a central axis of the micro light-emitting diode may be located on a same straight line. In this way, the lens can be configured to collimate the light emitted by the micro light-emitting diode, to improve light-emitting efficiency and light-emitting uniformity of the display module. In some other embodiments, the center axis of the lens may not be aligned with the center axis of the micro light-emitting diode, or may have a specific included angle with the center axis of the micro light-emitting diode, to adjust a light-emitting direction of the micro light-emitting diode.

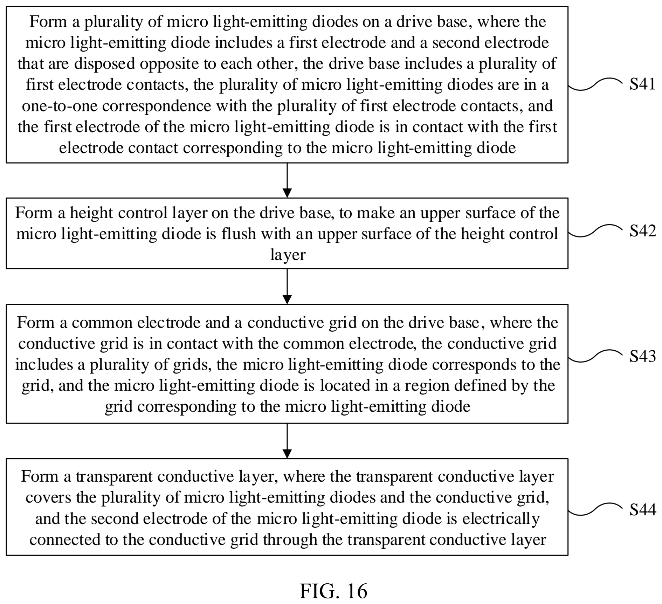

In addition, an embodiment of this application further provides a display module preparation method. Refer to FIG. 16. The method includes the following steps.

S41: Form a plurality of micro light-emitting diodes on a drive backplane, where the micro light-emitting diode includes a first electrode and a second electrode that are disposed opposite to each other, the drive backplane includes a plurality of first electrode contacts and a second electrode contact, the plurality of micro light-emitting diodes are in a one-to-one correspondence with the plurality of first electrode contacts, and the first electrode of the micro light-emitting diode is in contact with the first electrode contact corresponding to the micro light-emitting diode.

The plurality of micro light-emitting diodes are in a one-to-one correspondence with the plurality of first electrode contacts. The first electrode of the micro light-emitting diode is in contact with the corresponding first electrode contact to form an electrical connection, and a current signal may be injected into the micro light-emitting diode through the first electrode contact, to make the micro light-emitting diode emit light for display.

S42: Form a height control layer on the drive backplane, to make an upper surface of the micro light-emitting diode is flush with an upper surface of the height control layer.

A material of the height control layer has a different removal rate from a material of the micro light-emitting diode and a material of a dielectric filling layer. In this embodiment of this application, a height of the micro light-emitting diode in a light-emitting region is precisely controlled by using the height control layer. For example, a height of a wafer may stop at the upper surface of the height control layer, and the upper surface of the micro light-emitting diode is flush with the upper surface of the height control layer, so that height of the micro light-emitting diode is precisely controlled, and pixel light-emitting efficiency is improved.

S43: Form a common electrode and a conductive grid on the drive backplane, where the conductive grid is in contact with the common electrode, the conductive grid includes a plurality of grids, the micro light-emitting diode corresponds to the grid, and the micro light-emitting diode is located in a region defined by the grid corresponding to the micro light-emitting diode.

S44: Form a transparent conductive layer, where the transparent conductive layer covers the plurality of micro light-emitting diodes and the conductive grid, and the second electrode of the micro light-emitting diode is electrically connected to the conductive grid through the transparent conductive layer.

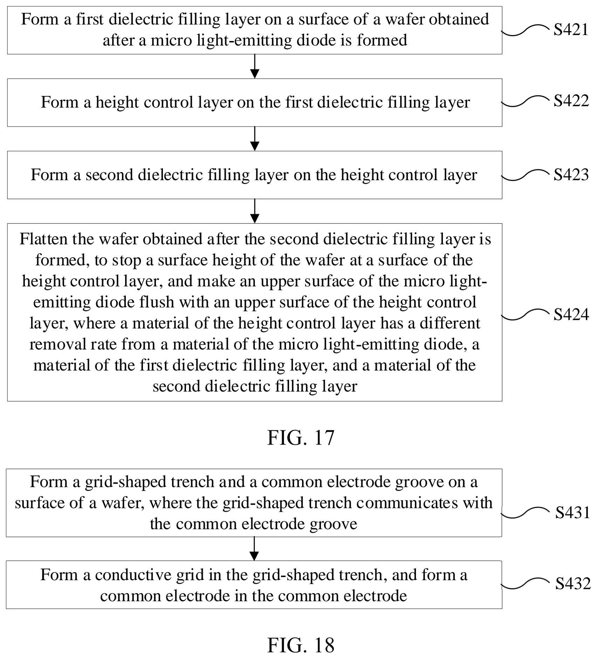

In this embodiment of this application, the height of the micro light-emitting diode is precisely controlled by using different removal rates between the material of the height control layer, and the material of the micro light-emitting diode and the material of the dielectric filling layer. Based on FIG. 16, with reference to FIG. 17, S42 includes the following steps.

S421: Form a first dielectric filling layer on a surface of a wafer obtained after the micro light-emitting diode is formed.

S422: Form the height control layer on the first dielectric filling layer.

S423: Form a second dielectric filling layer on the height control layer.

S424: Flattening the wafer obtained after the second dielectric filling layer is formed, to stop a surface height of the wafer at a surface of the height control layer, and make the upper surface of the micro light-emitting diode flush with the upper surface of the height control layer, where the material of the height control layer has a different removal rate from the material of the micro light-emitting diode, a material of the first dielectric filling layer, and a material of the second dielectric filling layer.

The material of the height control layer has a different removal rate from the material of the micro light-emitting diode, the material of the first dielectric filling layer, and the material of the second dielectric filling layer. In this way, a height of the wafer may stop at the surface of the height control layer during flattening the wafer, so that the upper surface of the micro light-emitting diode is flush with the upper surface of the height control layer.

Based on FIG. 16, refer to FIG. 18. In some embodiments of this application, S43 includes the following steps.

S431: Form a grid-shaped trench and a common electrode groove on the surface of the wafer, where the grid-shaped trench communicates with the common electrode groove.

In some embodiments of this application, the grid-shaped trench is formed in the light-emitting region and a peripheral region, and the common electrode groove is formed in the peripheral region. The second electrode contact is exposed at the bottom of the common electrode groove. The grid-shaped trench forms a plurality of grids. The micro light-emitting diode is disposed in a region defined by the grid in the light-emitting region, and the height control layer is disposed in a region defined by the grid in the peripheral region.

S432: Form the conductive grid in the grid-shaped trench, and form the common electrode in the common electrode groove.

Because the second electrode contact is exposed at the bottom of the common electrode groove, the common electrode formed in the common electrode groove is electrically connected to the second electrode contact. In addition, because the grid-shaped trench communicates with the common electrode groove, after the common electrode is formed in the common electrode groove and the conductive grid is formed in the grid-shaped trench, the conductive grid is in contact with the common electrode to form an electrical connection. The formed conductive grid may be made of a conductive metal material, for example, copper (Cu), aluminum (Al), tungsten (W), titanium nitride (TiN), tantalum nitride (TaN), titanium-tungsten alloy (TiW), a stacked structure of titanium-tungsten alloy-aluminum-titanium-tungsten alloy (TiW/Al/TiW), a stacked structure of titanium nitride-aluminum-titanium nitride (TiN/Al/TiN), a stacked structure of titanium-tungsten alloy-aluminium-titanium nitride (TiW/Al/TiN), or a stacked structure of titanium-tungsten alloy-tungsten-titanium nitride (TiW/W/TiN).

The following describes specific processes related to the foregoing steps with reference to the accompanying drawings.

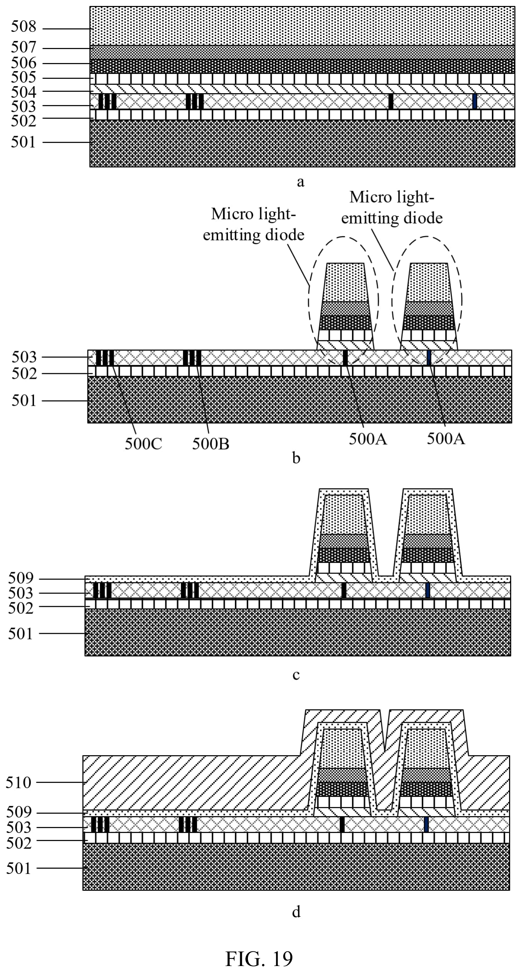

Refer to figure a in FIG. 19. A drive line layer 502, a protection layer 503, a bonding layer 504, an ohmic contact layer 505, a first semiconductor layer 506, a light-emitting layer 507, and a second semiconductor layer 508 are formed on a substrate 501. The substrate 501, the drive line layer 502, and the protection layer 503 form a drive backplane. The first semiconductor layer 506 may be a P-type semiconductor layer, and the second semiconductor layer 508 may be an N-type semiconductor layer.

Refer to figure b in FIG. 19. A part other than light-emitting pixels is removed to form a plurality of micro light-emitting diodes or micro light-emitting diode mesas. In some embodiments of this application, the drive backplane includes a light-emitting region and a peripheral region outside the light-emitting region. A plurality of first electrode contacts are disposed in the light-emitting region, for example, a first electrode contact 500A shown in b in FIG. 19. A second electrode contact, a pad contact, and the like are disposed in the peripheral region, for example, a second electrode contact 500B and a pad contact 500C shown in figure b in FIG. 19. An epitaxial structure above the first electrode contact may be retained, other structures may be removed by dry etching, to retain a surface of the drive backplane. In this way, the plurality of micro light-emitting diodes that are in a one-to-one correspondence with the first electrode contacts can be formed. The ohmic contact layer 505 may form a first electrode of the micro light-emitting diode, and the first electrode of the micro light-emitting diode is in contact with the first electrode contact corresponding to the micro light-emitting diode, to form an electrical connection.

Refer to figure c in FIG. 19. A passivation layer 509 is deposited on surfaces of the drive backplane and the micro light-emitting diode. For example, a material of the passivation layer 509 may be aluminum oxide, silicon oxide, or the like.

Refer to figure d in FIG. 19. A first dielectric filling layer 510 is deposited and formed on the passivation layer 509, and a material of the first dielectric filling layer 510 may be silicon oxide.

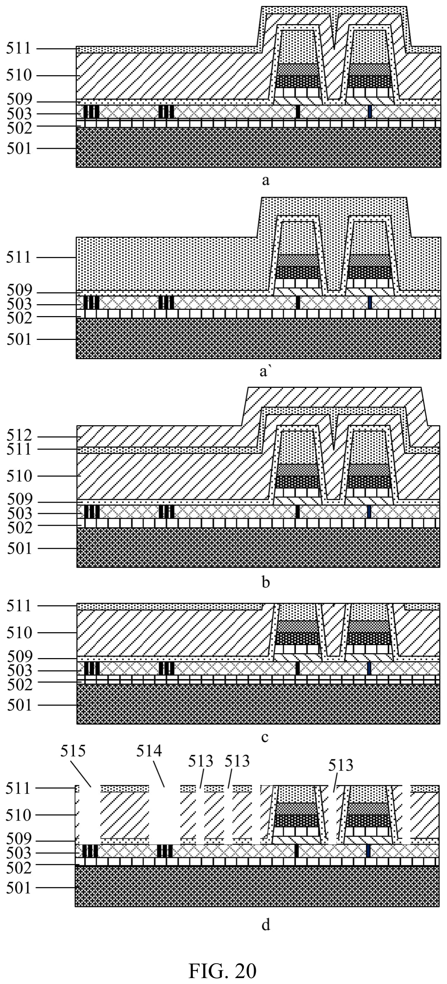

Refer to figure a in FIG. 20. A height control layer 511 is deposited and formed on the first dielectric filling layer 510. A material of the height control layer 511 has a different removal rate from a material of the dielectric filling layer and a material of the micro light-emitting diode. For example, the material of the height control layer 511 may be silicon nitride. The height control layer 511 is configured to control a height of the micro light-emitting diode. For example, in this embodiment of this application, a distance from an upper surface of the height control layer 511 to the surface of the drive backplane is the height of the micro light-emitting diode.

Alternatively, refer to figure a' in FIG. 20. The dielectric filling layer may not be disposed between the height control layer 511 and the drive backplane, and the height control layer 511 may be directly deposited and formed on the passivation layer 509.

Refer to figure b in FIG. 20. A second dielectric filling layer 512 is formed on the height control layer 511. A material of the second dielectric filling layer 512 may be the same as the material of the first dielectric filling layer 510. For example, the material of the second dielectric filling layer 512 may be silicon oxide.

Refer to figure c in FIG. 20. A surface of a wafer is flattened, for example, the surface of the wafer is flattened by using a CMP surface flatness process. Because the material of the height control layer 511 has a different removal rate from the material of the dielectric filling layer and the material of the micro light-emitting diode, a structure of a surface of the micro light-emitting diode may be removed, so that a surface height of the wafer stops at a surface of the height control layer 511, so that the height of the micro light-emitting diode is controlled. In this case, the upper surface of the micro light-emitting diode is flush with the upper surface of the height control layer 511, and a distance from the upper surface of the height control layer 511 to the surface of the drive backplane is the height of the micro light-emitting diode.

Refer to figure d in FIG. 20. A grid-shaped trench 513 and a common electrode groove 514 are formed on the surface of the wafer. The second electrode contact may be electrically connected to the common electrode 519 through a bottom line of the common electrode groove 514, and the grid-shaped trench 513 communicates with the common electrode groove 514. The micro light-emitting diode is disposed in a region defined by a grid formed by the grid-shaped trench in the light-emitting region, and the first dielectric filling layer 510 and the height control layer 511 are disposed in a region defined by a grid formed by the grid-shaped trench in the peripheral region. In some embodiments, a pad groove 515 is also formed by etching at a position corresponding to the pad contact.

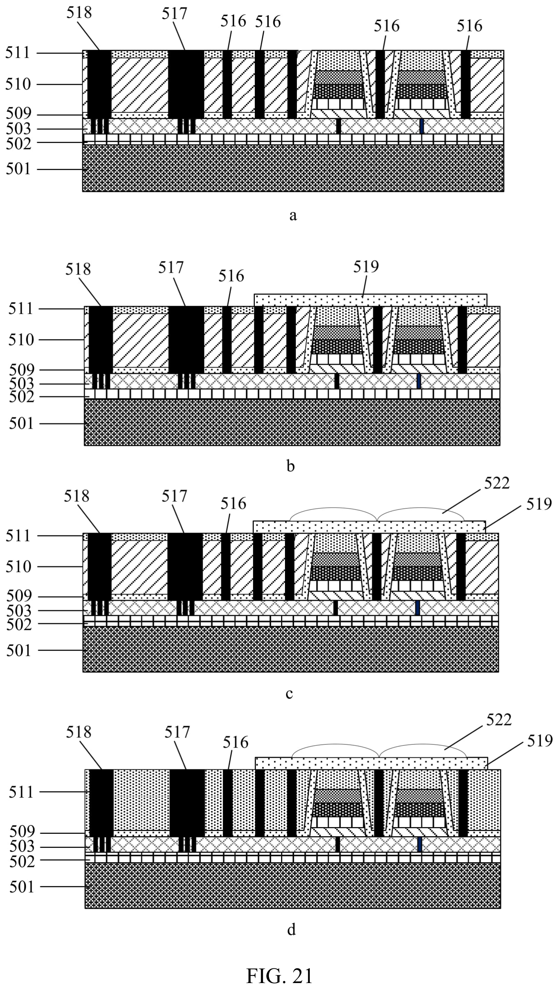

Refer to figure a in FIG. 21. A conductive grid 516 is formed in the grid-shaped trench 513, and a common electrode 519 is formed in the common electrode groove 514. The common electrode 519 is electrically connected to the second electrode contact. A pad 520 is formed in the pad groove 515. The conductive grid 516 is electrically connected to the common electrode 519. A height of the conductive grid 516 is not less than the height of the micro light-emitting diode.

Refer to figure b in FIG. 21. A transparent conductive layer 521 is prepared above the light-emitting region. A projection of the transparent conductive layer 521 onto the drive backplane covers the light-emitting region. The transparent conductive layer 521 is in contact with the second electrode of the micro light-emitting diode, or it may be considered that a part of the transparent conductive layer 521 in contact with the micro light-emitting diode forms the second electrode of the micro light-emitting diode. The transparent conductive layer 521 is further electrically connected to the conductive grid of the light-emitting region. In this way, the second electrode of the micro light-emitting diode may be electrically connected to the conductive grid and the common electrode through the transparent conductive layer.

Refer to figure c in FIG. 21. A lens layer 522 may be further prepared and formed on the transparent conductive layer 521. The lens layer 522 includes a plurality of lenses. The plurality of lenses are in a one-to-one correspondence with the plurality of micro light-emitting diodes. An axis of the lens and an axis of the micro light-emitting diode may be on a same straight line, or may form a specific angle.

Alternatively, with reference to figure a' in FIG. 20 and figure d in FIG. 21, figure d in FIG. 21 shows a display module in which no dielectric filling layer is disposed between the height control layer 511 and the drive backplane.

It can be learned from the processes shown in FIG. 19 to FIG. 21 that, in the method provided in this embodiment of this application, the plurality of micro light-emitting diodes are first formed on the drive backplane, and then the first dielectric filling layer 510, the height control layer 511, and the second dielectric filling layer 512 are sequentially formed. The surface of the wafer can stop at the surface of the height control layer 511 by using a feature of different removal rates of the height control layer 511 and the dielectric filling layer, to precisely control the height of the micro light-emitting diode. After the height of the micro light-emitting diode is controlled, the conductive grid 516 is formed by trenching. Finally, the transparent conductive layer 521 is prepared and formed on the light-emitting region. The conductive grid 516 may change a current path of the micro light-emitting diode, so that a current that originally flows through the transparent conductive layer 521 to the common electrode 519 flows through the conductive grid 516 to the common electrode 519. This can reduce a resistance and prevent an IR drop from affecting the display effect. In addition, the conductive grid 516 may be an opaque grid. The micro light-emitting diode may be disposed in a grid aperture formed by the conductive grid 516. The conductive grid 516 may block light emitted by different micro light-emitting diodes, to avoid crosstalk of the light emitted by the different micro light-emitting diodes.

An embodiment of this application further provides an electronic device. The electronic device includes a housing and the display module provided in the foregoing example. The display module may be mounted on the housing. For example, the electronic device may be an electronic device for example, a mobile phone (mobile phone), a personal computer (personal computer, PC), a tablet computer (pad), an intelligent wearable product (for example, a smart watch or a smart band), a virtual reality (virtual reality, VR) terminal device, an augmented reality (augmented reality, AR) terminal device, a vehicle-mounted terminal, or a display mentioned in the foregoing examples.

In descriptions of this specification, specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A display module, wherein the display module comprises:
a drive backplane, comprising a plurality of first electrode contacts and a second electrode contact, wherein the first electrode contact and the second electrode contact are configured to form a drive loop with a micro light-emitting diode;
a plurality of micro light-emitting diodes, wherein the micro light-emitting diode comprises a first electrode and a second electrode, the plurality of micro light-emitting diodes are in a one-to-one correspondence with the plurality of first electrode contacts, and the first electrode of the micro light-emitting diode is electrically connected to the first electrode contact;
a conductive grid, wherein the conductive grid comprises a plurality of grids, and the conductive grid is electrically connected to the second electrode contact; and
a transparent conductive layer, wherein the transparent conductive layer covers the plurality of micro light-emitting diodes and the conductive grid, the second electrode of the micro light-emitting diode is electrically connected to the conductive grid through the transparent conductive layer, and resistivity of a material of the conductive grid is lower than resistivity of a material of the transparent conductive layer.

2. The display module according to claim 1, wherein a common electrode is further disposed on the drive backplane, and the conductive grid is electrically connected to the second electrode contact through the common electrode.

3. The display module according to claim 1, wherein the conductive grid is electrically connected to the second electrode contact through an internal line of the drive backplane.

4. The display module according to any one of claims 1 to 3, wherein a height control layer is further disposed on the drive backplane, and an upper surface of the micro light-emitting diode is flush with an upper surface of the height control layer.

5. The display module according to claim 4, wherein the display module further comprises a dielectric filling layer, the dielectric filling layer is disposed between adjacent micro light-emitting diodes and between the height control layer and the drive backplane, and a material of the height control layer has a different removal rate from a material of the dielectric filling layer and a material of the micro light-emitting diode.

6. The display module according to any one of claims 1 to 5, wherein a plurality of micro light-emitting diodes are disposed in a region defined by each grid.

7. The display module according to any one of claims 1 to 5, wherein one micro light-emitting diode is disposed in a region defined by each grid.

8. The display module according to any one of claims 1 to 7, wherein a width of a grid line of the conductive grid ranges from 10 nm to 1000 nm.

9. The display module according to any one of claims 1 to 8, wherein the conductive grid comprises a lower surface facing the drive backplane and an upper surface facing away from the drive backplane in a direction perpendicular to the drive backplane, and the micro light-emitting diode comprises a lower surface facing the drive backplane and the upper surface facing away from the drive backplane in the direction perpendicular to the drive backplane;
a distance from the lower surface of the conductive grid to the drive backplane is less than or equal to a distance from the lower surface of the micro light-emitting diode to the drive backplane; and
a distance from the upper surface of the conductive grid to the drive backplane is greater than or equal to a distance from the upper surface of the micro light-emitting diode to the drive backplane.

10. The display module according to any one of claims 1 to 9, wherein a height of the conductive grid in the direction perpendicular to the drive backplane is 1 to 2 times a height of the micro light-emitting diode in the direction perpendicular to the drive backplane.

11. The display module according to any one of claims 1 to 9, wherein the display module further comprises a lens layer, the lens layer is disposed on the transparent conductive layer, and the lens layer is configured to collimate light emitted by the micro light-emitting diode.

12. A display module preparation method, wherein the method comprises:
forming a plurality of micro light-emitting diodes on a drive backplane, wherein the micro light-emitting diode comprises a first electrode and a second electrode that are disposed opposite to each other, the drive backplane comprises a plurality of first electrode contacts and a second electrode contact, the plurality of micro light-emitting diodes are in a one-to-one correspondence with the plurality of first electrode contacts, and the first electrode of the micro light-emitting diode is in contact with the first electrode contact corresponding to the micro light-emitting diode;
forming a common electrode and a conductive grid on the drive backplane, wherein the common electrode is electrically connected to the second electrode contact, the conductive grid is electrically connected to the common electrode, the conductive grid comprises a plurality of grids, the micro light-emitting diode corresponds to the grid, and the micro light-emitting diode is located in a region defined by the grid corresponding to the micro light-emitting diode; and
forming a transparent conductive layer, wherein the transparent conductive layer covers the plurality of micro light-emitting diodes and the conductive grid, and the second electrode of the micro light-emitting diode is electrically connected to the conductive grid through the transparent conductive layer.

13. The method according to claim 12, wherein before forming the common electrode and the conductive grid on the drive backplane, the method further comprises:
forming a height control layer on the drive backplane, and making an upper surface of the micro light-emitting diode flush with an upper surface of the height control layer.

14. The method according to claim 13, wherein forming the height control layer on the drive backplane, and making the upper surface of the micro light-emitting diode flush with the upper surface of the height control layer comprise:
forming a first dielectric filling layer on a surface of a wafer obtained after the micro light-emitting diode is formed;
forming the height control layer on the first dielectric filling layer;
forming a second dielectric filling layer on the height control layer; and
flattening the wafer obtained after the second dielectric filling layer is formed, to stop a surface height of the wafer at a surface of the height control layer and make the upper surface of the micro light-emitting diode flush with the upper surface of the height control layer, wherein a material of the height control layer has a different removal rate from a material of the micro light-emitting diode, a material of the first dielectric filling layer, and a material of the second dielectric filling layer.

15. The method according to claim 13 or 14, wherein forming the common electrode and the conductive grid on the drive backplane, and making the conductive grid in contact with the common electrode comprise:
forming a grid-shaped trench and a common electrode groove on the surface of the wafer obtained after the height control layer is formed, wherein the grid-shaped trench communicates with the common electrode groove; and
forming the conductive grid in the grid-shaped trench, and forming the common electrode in the common electrode groove.

16. An electronic device, comprising a housing and the display module according to any one of claims 1 to 11, wherein the display module is mounted on the housing.
